# EUROPEAN PATENT APPLICATION

(11) **EP 4 219 803 A1**
(43) Date of publication of application: **02.08.2023**
(21) Application number: 22154305.1
(22) Date of filing: 31.01.2022
(51) Int. Cl.: C30B 15/10, C30B 15/14, C30B 15/20, C30B 29/16

(54) **METHOD AND APPARATUS FOR PRODUCING ELECTRICALLY CONDUCTING BULK BETA-GA2O3 SINGLE CRYSTALS AND ELECTRICALLY CONDUCTING BULK BETA-GA2O3 SINGLE CRYSTAL**

(71) Applicant: Siltronic AG, 81677 München (DE)
(72) Inventor: Galazka, Zbigniew, 12489 Berlin (DE); Bickermann, Matthias, 12355 Berlin (DE); Ganschow, Steffen, 10435 Berlin (DE); Schröder, Thomas, 12489 Berlin (DE); Häckl, Walter, 84558 Kirchweidach (DE)

(57) **Abstract**

Method and apparatus for producing electrically conducting bulk β-Ga₂O₃ single crystals grown from the melt, especially by the Czochralski method. To growth the β-Ga₂O₃ single crystals (**7**) of high electrical conductivity and large diameter, larger than one inch, combined with the length exceeding 25 mm, the growth furnace is provided with an inner thermal insulation (**8**) of low radiative reflectivity (**R**) in the near infrared spectral region of 1 - 3 µm that decreases reflections of heat back to the growing single crystal (**7**) and thus increases the heat dissipation from the growing single crystal (**7**). Low reflectivity can be achieved either by high emissivity or high transmittivity. Additionally, the β-Ga₂O₃ single crystal (**7**) is grown at a rate that dynamically decreases as the growth proceeds, to dynamically decrease the latent heat of crystallization and the amount of the heat to be dissipated from the growing single crystal (**7**).

## Description

### TECHNICAL FIELD

The present invention relates to a method and apparatus for growing bulk β-Ga₂O₃ single crystals by the Czochralski method in general, and in particular, for electrically conducting crystals of large diameter. The invention also relates to an electrically conducting bulk β-Ga₂O₃ single crystals grown by the Czochralski method, especially of large diameter.

### BACKGROUND OF THE INVENTION

Beta-phase of Ga₂O₃ (β-Ga₂O₃) is an emerging ultra-wide band gap n-type oxide semiconductor with high potential for UV optoelectronic and high-power electronic applications. This is the result of a wide bandgap of 4.85 eV that makes that compound transparent down to UV spectral region and high theoretical breakdown field of 8 MV/cm.

For devices bulk single crystals are required, which serve as substrates for epitaxial layers and then device structure fabrication thereon. Although foreign substrates can be used for such purposes, they usually deteriorate the quality of the layers and consequently a device performance, due to lattice mismatch between the substrate and the layer. For that reason, native substrates are demanded.

β-Ga₂O₃ - based power devices, such as Schottky diodes and field effect transistors (FETs) can be economically efficient in terms energy saving and energy management. They can find applications in a number of industrial areas, such as mobile transportation, including electric cars, aircrafts, and vessels, as well as railways, or power grids. Generally, power switching devices can be designed in two configurations: horizontal (planar) and vertical. In the horizontal configuration, the substrate is electrically insulating and acts as a support for the layer with all contacts thereon, e.g. source, drain, and gate contacts in an FET device. In the vertical configuration, the substrate is highly conducting and acts as an electrical contact in addition to support the epitaxial layer. The devices in the vertical configuration can switch higher voltages as compared with the horizontal configuration.

Bulk β-Ga₂O₃ single crystals are known in the art and can be grown from the melt by different techniques: the Optical Floating Zone (OFZ), Edge-Defined Film-Fed Growth (EFG), Bridgman or Vertical Gradient Freeze (VGF), and Czochralski methods.

The OFZ method, which is crucible-free method, can produce only small diameter crystals, not exceeding one inch. Examples of this method used for growing bulk β-Ga₂O₃ single crystals can be found in the paper to E. G. Villora et al. entitled "Large-size β-Ga2O3 single crystals and wafers", J. Cryst. Growth 270 (2004) 420-426, and in the US patent document No. US 8,747,553 B2. The OFZ method enables to growth both electrically insulating and electrically conducting bulk β-Ga₂O₃ single crystals along different crystallographic directions, since the growth proceeds on the top of a crystal seed.

The EFG method for growing bulk β-Ga₂O₃ single crystals uses an Ir crucible and an Ir die (shaper) on the top of the crucible. Typically, the crystals are grown in the form of slabs along the <010> crystallographic direction with the (201) or (001) principal faces (i.e. large faces of the slabs), which can reach as large size as 4 or 6 inch. However, (010)-oriented substrates can be prepared only from the cross-section of the crystal slabs, which are of 10×15 mm². Examples of this method in relation to bulk β-Ga₂O₃ single crystals are disclosed in the paper to A. Kuramata et al. entitled "High-quality β-Ga2O3 single crystals grown by edge-defined film-fed growth", Jpn. J. Appl. Phys. 55 (2016) 1202A2, and in the patent / patent application documents: WO 2013172227 A1 (corresponding JP6,421,357 B2; EP 2851458 A4; US 2015125699 A1), WO 2013073497 A1 (JP 5,491,483 B2; EP 2,801,645 B1; US 2014352604 A1), and WO 2014073314 A1 (JP5,756,075 B2, EP2,933,359 B1, US9,926,646 B2). Cylindrical β-Ga₂O₃ crystals grown by the EFG method have been disclosed, for example, in the patent application document No. CN 112210823 A.

The Bridgman and VGF methods used for growing bulk β-Ga₂O₃ single crystals utilize a noble metal crucible, like Pt-Rh alloy (Bridgman) or Ir (VGF) crucibles, within which the melt solidifies into a single crystal on a top of a crystal seed, which may have a different crystallographic orientation. By this method both electrically insulating and electrically conducting β-Ga₂O₃ single crystals can be grown. The VGF method, described in the paper by Galazka et al. entitled "Scaling-Up of Bulk β-Ga2O3 Single Crystals by the Czochralski Method", ECS J. Solid State Sci. Technol. 6 (2017) Q3007-Q3011 allows for growing highly conducting β-Ga₂O₃ single crystals of almost 2 inch diameter, but they are short, not exceeding 20 mm. The growth of bulk β-Ga₂O₃ single crystals by the Bridgman method is disclosed in the US patent document No. US10,570,528 B2 to K. Hoshikawa et al. The Bridgman method, reported by K. Hoshikawa et al., in the paper entitled "2-inch diameter (100) β-Ga2O3 crystal growth by the vertical Bridgman technique in a resistance heating furnace in ambient air", J. Cryst. Growth, 545 (2020) 125724, enables to grow 2 inch diameter, electrically insulating crystals perpendicular to the (100) plane, but their cylindrical length does not exceed about 25 mm. The same crystal dimensions relate to electrically conducting crystals grown by Bridgman method with the orientation perpendicular to the (001) plane, as discussed in the paper to Hoshikawa et al. entitled "50 mm diameter Sn-doped (001) β-Ga2O3 crystal growth using the vertical Bridgeman technique in ambient air", J. Cryst. Growth 546 (2020) 125778.

The Czochralski method offers the possibility of growing the largest bulk β-Ga₂O₃ single crystals in terms of volume combined with high structural quality. Electrically insulating crystals of two inch diameter can be as long as 60 - 100 mm, as reported by Galazka et al. in the papers entitled: "Scaling-Up of Bulk β-Ga2O3 Single Crystals by the Czochralski Method", ECS J. Solid State Sci. Technol. 6 (2017) Q3007-Q3011; "β-Ga2O3 for wide-bandgap electronics and optoelectronics", Semicond. Sci. Technol. 33 (2018) 113001, and "Bulk single crystals of β-Ga2O3 and Ga-based spinels as ultra-wide bandgap transparent semiconducting oxides", Prog. Cryst. Growth Charact. Mater. 67 (2021) 100511. To grow such large crystals, high oxygen partial pressure in a growth atmosphere is required to minimize the formation of elemental Ga in the Ga₂O₃ melt, that have a high, negative impact on the growth process, crucible lifetime, and crystal quality, if obtained at all. This requirement is necessary for all melt growth methods used for β-Ga₂O₃ single crystals that involve a noble metal crucible, as taught by Galazka et al. in the European patent description No. EP 3,242,965 B1 (corresponding US 11,028,501 B2).

Although electrically insulating bulk β-Ga₂O₃ single crystals can be of large size in terms of diameter and cylindrical length, this does not relate to electrically conducting crystals, which suffer from so called free carrier absorption. Simply, the heat generated during liquid-solid phase transition (latent heat of crystallization) cannot be easily dissipated by the growing crystal, because it is absorbed by the free carriers in the growing crystal in the near infrared spectral region, in which the most of the heat is transported through the growing crystal. It causes a temperature increase near the growth interface and consequently interface inversion from a convex to a concave towards the melt. Such concave growth interface leads to grow instabilities that changes the growth morphology from a cylindrical to a corkscrew (spiral) shape. The spiral does not allow to fabricate wafers of a demanded diameter. This phenomenon in relation to bulk β-Ga₂O₃ single crystals grown by the Czochralski method has been described by Galazka et al. in the papers entitled: "On the bulk β-Ga2O3 single crystals grown by the Czochralski method", J. Cryst. Growth 404 (2014) 184-191; "Czochralski-grown bulk β-Ga2O3 single crystals doped with mono-, di-, tri-,and tetravalent ions", J. Cryst. Growth 529 (2020) 125297; "Bulk β-Ga2O3 single crystals doped with Ce, Ce+Si, Ce+AI, and Ce+AI+Si for detection of nuclear radiation", J. Alloy. Compd. 818 (2020) 152842; and "Transparent Semiconducting Oxides - Bulk Crystal Growth and Fundamental Properties", Chapter 4, Jenny Stanford Publishing (2020). As the result, highly conducting crystals with the free electron concentration above 10¹⁸ cm⁻³ can be grown by the Czochralski method as short cylinders, about 30 mm for crystal diameter of or below one inch, and below 25 mm in the case of two diameter crystals. For economical reasons, especially when taking into accounts very high costs of crystal growth, the cylindrical part of the crystal should be as long as possible to fabricate as many wafers from one crystal as possible, while maintaining pre-defined electrical properties for electronic devices, in particular in the vertical configuration. The Czochralski method enables to growth crystals along the <010> crystallographic direction, therefore, (010)-oriented wafers that are fabricated from the cross-section of the cylindrical part. For example, 2 inch diameter crystals grown along the <010> direction enable to fabricate 2 inch diameter (010)-oriented wafers of high electrical conductivity, suitable for power devices in the vertical configuration.

Electrical conductivity of undoped bulk β-Ga₂O₃ single crystals, independent on the growth method, arise from the residual impurities, mainly silicon and/or hydrogen, which can induce electrical conductivity classified as normal semiconductors, where the free electron concentration does not exceed the value of about 10¹⁸ cm⁻³. For higher electrical conductivity, intentional doping is required, which is typically performed with silicon (Si) or tin (Sn) doping as discussed e.g. in the above-mentioned state of the art. Also, other dopants are occasionally used to induce electrical conductivity in β-Ga₂O₃, such as Nb, Hf, or Zr.

### SUMMARY OF THE INVENTION

An object of the present invention is to provide conditions for producing bulk β-Ga₂O₃ single crystals from the melt, especially by the Czochralski method, which will ensure the grow the crystals of high electrical conductivity, large size, and high structural quality.

Another object of the present invention is to provide bulk β-Ga₂O₃ single crystals of high electrical conductivity and large size, preferably of at least 2 inch diameter and over one inch long.

Yet another object of the present invention is to provide an apparatus for producing β-Ga₂O₃ single crystals from the melt, especially by the Czochralski method, which will enable to carry out the said method and thus to grow the crystals of high electrical conductivity, large size, and high structural quality.

In a more general aspect, a yet further object of the present invention is to provide a method and apparatus for producing different oxide compounds by the Czochralski method, which have high melting points (above 1400°C) and show strong absorption in the near infrared spectral region.

According to the first aspect of the invention, a method for producing electrically conducting bulk β-Ga₂O₃ single crystals by the Czochralski method comprises the step of providing, to a growth chamber, a growth furnace comprising a noble metal crucible with a Ga₂O₃ starting material therein, a thermal insulation surrounding the crucible from all sides with a free space to accommodate a growing bulk β-Ga₂O₃ single crystal, and an inductive RF coil for heating up the crucible and control the melt temperature during crystal growth, wherein the RF coil is powered by an RF generator, while the growing crystal is fixed through a crystal seed, seed holder, and a pulling rod to a translation and rotating mechanisms. The method further comprises the step of providing, to the Ga₂O₃ starting material, a dopant forming a shallow donor in the Ga₂O₃ single crystal, as well as the step of providing to the growth chamber and thus to the growth furnace a growth atmosphere containing oxygen mixed with at least one non-reducing gas. Next the crucible with the Ga₂O₃ starting material is heated-up by the RF coil until melting the Ga₂O₃ starting material. After melting the Ga₂O₃ starting material, the oriented crystal seed is dipped into the molten starting material, which is than pulled up with a translation rate to achieve a predefined growth rate while rotating at a predefined rotation rate. During initial puling, the seed diameter is expanded to a final cylindrical diameter, which is pulled to a predefined cylindrical length. Once the predefined cylindrical length is achieved, the single crystal is separated from the melt and cooled down, together with the growth furnace, to room temperature.

The essence of the invention is to additionally provide to the growth furnace an inner thermal insulation of low radiative reflectivity in the near infrared spectral region of 1 -3 µm to decrease reflections of heat back to the growing single crystal and thus to increase the heat dissipation from the growing single crystal. This is combined with a dynamic decrease of the growth rate from the beginning of pulling up the crystal seed to crystal separation. The growth rate decreases from the initial growth rate of 1 - 10 mm/h at the beginning of the growth to a final growth rate of 0.2 - 1 mm/h at the end of the growth when the single crystal had achieved the predefined cylindrical length. This solution dynamically decreases the latent heat of crystallization as the growth proceeds and the amount of the heat to be dissipated from the growing single crystal.

Preferably, the inner thermal insulation with low radiative reflectivity has high emissivity or high reflectivity in the near infrared spectral region, above 0.3 at room temperature.

The growth rate may decrease from the initial growth rate to the final growth rate either linearly or non-linearly.

In a preferred embodiment, the growth rate decreases from the initial growth rate to the final growth rate at different rates.

In another preferred embodiment, the growth rate may decrease from the initial growth rate to the final growth rate continuously or in blocks combining constant and decreasing growth rates.

Advantageously, the growth atmosphere comprises, in addition to oxygen, a non-reducing gas of high thermal conductivity, preferably He in a concentration of 10 - 95 vol. % to further enhance heat dissipation from the growing crystal via gas convection.

According to the second aspect of the invention an electrically conducting bulk β-Ga₂O₃ single crystal grown by the Czochralski method are provided according to the above-described method. The β-Ga₂O₃ single crystal has the cylindrical diameter larger than one inch, cylindrical length larger than 25 mm, and the following electrical properties formed by shallow donors according to Hall effect measurements: free electron concentration of 1 - 10×10¹⁸ cm⁻³, electron mobility of 50 - 120 cm²V⁻¹s⁻¹, and the resistivity of 0.01 - 0.04 Qcm.

In a preferred embodiment of the present invention, the β-Ga₂O₃ single crystal has the cylindrical diameter of two inch or larger.

Advantageously, the dopants forming shallow donors are Si and/or Sn.

According to the third aspect of the invention, an apparatus for producing electrically conducting bulk β-Ga₂O₃ single crystals by the Czochralski method having a pre-defined cylindrical diameter and cylindrical length. The apparatus comprises a growth chamber and a growth furnace comprising a noble metal crucible with a Ga₂O₃ starting material therein, a thermal insulation surrounding the crucible from all sides with a free space to accommodate a growing bulk β-Ga₂O₃ single crystal, and an inductive RF coil for heating up the crucible and control the melt temperature during crystal growth. The apparatus further comprises an RF generator powering the RF coil, translation and rotation mechanisms coupled with a crystal seed through a seed holder, and a pulling rod, as well as a scale connected with the pulling rod or the growth furnace for monitoring growth rate of the bulk β-Ga₂O₃ single crystal.

According to the present invention, the growth furnace further comprises an inner thermal insulation of low radiative reflectivity in the near infrared spectral region of 1 - 3 µm that decreases reflections of heat back to the growing single crystal and thus increases the heat dissipation from the growing single crystal.

Advantageously, the inner thermal insulation with low radiative reflectivity has high emissivity in the near infrared spectral region, above 0.3 at room temperature. Here, the inner thermal insulation is preferably selected from the group consisting of opaque alumina, zirconia, magnesia, and yttria.

In another advantageous solution of the present invention, the inner thermal insulation with low radiative reflectivity has high transmissivity in the near infrared spectral region, above 0.3 at room temperature. This is preferably met by transparent ceramic selected from the group consisting of alumina, yttria, and yttrium aluminum garnet, or by a crystalline sapphire.

In a preferred embodiment of the apparatus, the growth atmosphere contains, in addition to oxygen, a non-reducing gas of high thermal conductivity, most preferably He in a concentration of 5 - 95 vol. % to further enhance heat dissipation from the growing crystal via gas convection

More advantages and other features of the inventive method and apparatus for growing bulk β-Ga₂O₃ single crystals or other oxide crystals revealing high absorption in the near infrared spectral region will be apparent from the detailed description of the embodiments in reference to the drawings.

### BRIEF DESCRIPTION OF THE DRAWINGS

**Figure 1** is a schematic growth furnace for oxide single crystals grown by the Czochralski method in a cross-sectional view;
**Figure 2** shows different profiles of growth rates of bulk β-Ga₂O₃ single crystals grown by the Czochralski method; and
**Figure 3** shows a real growth rate profile outputted from a growth run of bulk β-Ga₂O₃ single crystal grown by the Czochralski method.

### DETAILED DESCRIPTION OF THE EMBODIMENTS

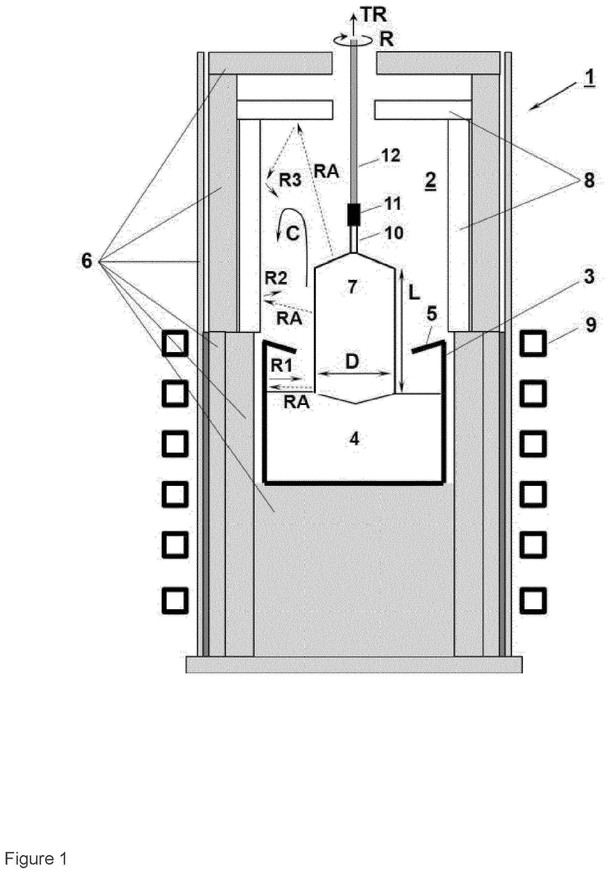

The growth furnace **1** shown in Fig. 1 is adapted for growing bulk oxide single crystals by the Czochralski method in general, and in particular for growing bulk β-Ga₂O₃ single crystals by the Czochralski method. The growth furnace **1** is accommodated within a water-cooled growth chamber (not shown) to which a pre-defined growth atmosphere **2** is introduced. The furnace **1** consists of a noble metal crucible **3** containing a Ga₂O₃ starting material **4,** preferably with a lid **5** thereon, and a thermal insulation **6** surrounding the crucible from all sides. Above the crucible there is a free space (growth zone) that accommodates a growing bulk β-Ga₂O₃ single crystal **7.** The growth furnace **1** further includes an inner thermal insulation **8** of defined optical properties, as explained further below. The noble metal crucible **5** is inductively heated by an RF coil **9** situated outside the thermal insulation **6** and powered by a RF generator (not shown). The bulk β-Ga₂O₃ single crystal **7** is grown on a crystallographically oriented β-Ga₂O₃ crystal seed **10** that is fixed to a seed holder **11** connected to a pulling rod **12**. The pulling rod **12** is connected to a pulling and rotation mechanisms (not shown) for translating **TR** and rotating **R** the growing β-Ga₂O₃ single crystal **7,** and to a scale (not shown) for weighting the growing β-Ga₂O₃ single crystal **7.** Alternatively, the scale is coupled with the growth furnace **1.** In each case, the scale indicates the growth rate of the growing single crystal **7** by weighting directly the crystal mass or a mass difference between the furnace and the growing crystal **7.** A signal from the scale is coupled with a controller that controls the generator power, and thus the melt temperature.

The thermal insulation **6** is a refractory material that withstands high temperatures, depending on the melting point of an oxide crystal to be grown. The melting point of Ga₂O₃ is about 1800°C. The thermal insulation **6** typically includes alumina or zirconia tubes, granules, felts, as well as quartz tubes on outer parts of the growth furnace **1.** The aim of the thermal insulation **6** is to decrease heat losses and establish pre-defined temperature gradients in the crucible and in the growth zone to minimize thermal stresses and associated structural and point defects in the growing crystal **7.** In particular, for growing bulk β-Ga₂O₃ single crystals low temperature gradients are required and thus as good thermal insulation as possible. This is the result and melt chemistry (decomposition) and monoclinic system of β-Ga₂O₃ having anisotropic mechanical, thermal, and optical properties.

The noble metal crucible **3** for β-Ga₂O₃ crystals is iridium and its alloys, like iridium-platinum alloy. Also, other crucible materials can be considered, like platinum-rhodium alloy, which is described by Hoshikawa et al. (described above) for the Bridgman method.

The growth atmosphere **2** for growing the β-Ga₂O₃ single crystal **7,** in particular of large diameter, larger than 1 inch, contains oxygen, preferably at least 5 vol.%, and at least one another non-reducing gas, like Ar, N₂, CO₂, He, Xe, and Ne, as described in the patent No. US 11,028,501 B2 to Galazka et al., incorporated here as a reference.

For the Czochralski method the β-Ga₂O₃ crystal seed **10** is crystalographically oriented along the [010] direction, parallel to both easy (100) and (001) cleavage planes that are present in the monoclinic system of β-Ga₂O₃. Other seed orientations inclined to the [010] direction, e.g. [110], can be used as well.

A crystal growth process is as follows. After assembling the growth furnace **1,** the noble metal crucible **3** with the starting material **4** is heated up by the RF coil **9** until melting the Ga₂O₃ starting material **4.** Once the Ga₂O₃ melt is thermally stabilized, the oriented β-Ga₂O₃ crystal seed **10** is dipped into the Ga₂O₃ melt while rotating at the rotation rate **R.** Next the oriented β-Ga₂O₃ crystal seed **10** is pulled upwards at the translation rate **TR** with expanding its diameter to a predefined cylindrical diameter **D,** by a gradual decrease of the melt temperature via the RF generator. When the crystal achieves a pre-defined cylindrical length **L,** it is separated from the melt, slowly cooled down to room temperature, and removed from the growth furnace **1.**

The problem of growing electrically conducting (normally or degenerately semiconducting) bulk β-Ga₂O₃ single crystals by the Czochralski method as long straight cylinders arises from intrinsic properties of that compound, i.e. from the absorption of the heat transported through the growing crystal by free carriers. The heat, that must be dissipated away from the crystal is generated at the growth interface during liquid-solid phase transition. The interface is convex towards the melt (i.e. a conical portion of the crystal is immersed in the melt) and assures a stable growth. The heat absorbed by the free carriers increases temperature of the crystal near the growth interface and at certain crystal length the heat cannot be easily dissipated away. Once the temperature in the crystal reaches the melting point of Ga₂O₃, a portion of the crystal immersed in the melt is melted back. This phenomenon is called an interface inversion. After that interface inversion the growth becomes unstable and the growth morphology changes from a straight cylinder to a corkscrew (spiral). Such crystal shape does not enable to prepare wafers of the diameter as expected from the straight cylinder, so the usable portion of the crystal for wafering is only that cylindrical part. The length of the cylindrical part of highly conducting β-Ga₂O₃ crystal with the diameter larger than one inch is not longer than 25 mm. High electrical conductivity of a crystal β-Ga₂O₃ crystal is understood as the free electron concentration exceeding a value of 10¹⁸ cm⁻³.

To increase the length of the cylindrical part of a highly electrically conducting β-Ga₂O₃ crystal of a diameter above 1 inch, grown by the Czochralski method, the following technical solutions were found to be effective:
(i) a decrease of the heat amount reflected form the inner thermal insulation back to the growing β-Ga₂O₃ single crystal: and/or
(ii) a dynamic decrease of the latent heat of crystallization as the growth proceeds.

As shown in Fig. 1, the crystal surface dissipates and exchanges the heat with the surrounding in two ways: by a gas convection **C**, and by the radiation **RA,** the latter being much more effective. In the radiative heat exchange, the heat leaving the crystal surface in all directions is interacting with the metal crucible **3** and its lid **5** (if present), and with the inner thermal insulation **8,** where it is partly reflected, partly absorbed, and partly transmitted therethrough. This can be described in the dimensionless measure as: **THA** = 1 = **R** + **E** + **T,** where **THA** is the total heat amount, **R** is the reflectivity, **E** is the emissivity, and **T** is the transmissivity. Therefore, the reflectivity can be described as: **R** = 1 - **E** - **T.** To minimize heat reflections from the inner thermal insulation **8,** it should have either high emissivity **E** or high transmissivity **T.** These optical properties **R, E,** and **T** relate the near infrared (NIR) region in which the vast majority of heat is transported. Taking into accounts the melting point of Ga₂O₃ (1800°C), the black body radiation at that temperature, and lower temperature of the growing crystal (assuming 1200°C as the lowest), the NIR region is between 1 - 3 µm. So, the requirements for the inner thermal insulation **8** is low reflectivity **R** in the 1 - 3 µm spectral region, which can be achieved by high **E** or **T** values in that spectral region. The optical properties of materials strongly depend on the spectral region and temperature. For instance, the emissivity **E** changes in the NIR spectral region in a wide range, also at high temperatures, therefore, it is difficult to define precise values, however, smaller **E** values at some subregions of the discussed NIR region will not have a big impact on the overall heat exchange. In any case, the emissivity **E** should be larger than 0.3 in the NIR spectral region of 1 - 3 µm when measured at room temperature. Suitable refractory materials for the inner thermal insulation **8** are: alumina, zirconia, yttria, and magnesia, preferably with a rough surface to enhance diffuse scattering.

Another solution is to increase transmissivity **T** of the inner thermal insulation **8.** This can be achieved by thermal insulation transparent to the above-defined NIR spectral region. As the standard refractory materials are basically opaque to NIR, transparent ceramic or crystalline sapphire can be used. Both transparent ceramics, e.g. alumina and yttria, and crystalline sapphire in different shapes (tubes and lids) are available. To the transmissivity **T** the same considerations apply versus wavelength and temperature as in the case to the emissivity **E.** Also, in this case the transmissivity **T** should be larger than 0.3 in the NIR spectral region of 1 - 3 µm when measured at room temperature.

Another, above-mentioned solution for more effective heat dissipation from the crystal is a dynamic decrease of the amount of heat generated during growth. This is done by a dynamic lowering the growth rate with the crystal length. It should be noted that the growth rate **V** combines the translation rate **TR** of the crystal and the melt drop, which is converted to solid.

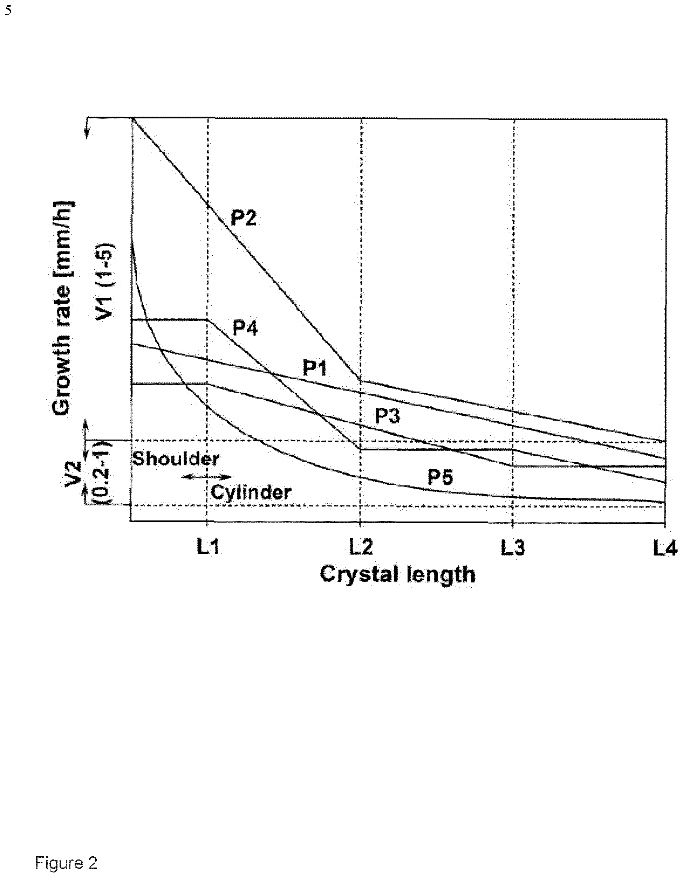

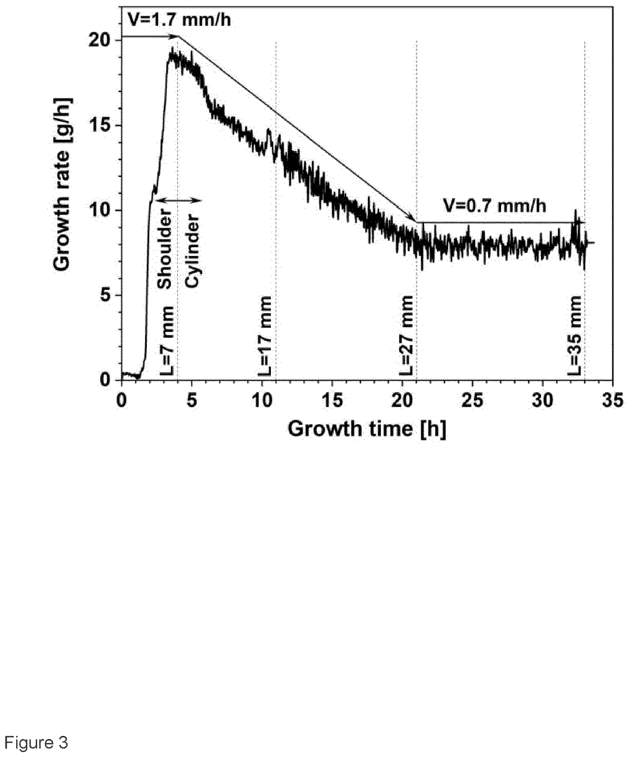

Fig. 2 illustrates profiles of the growth rates **V** that enable to decrease the latent heat of crystallization in a dynamic way. Generally, at the beginning of the growth, i.e. during seeding, seed expansion (shoulder) and the beginning of the cylindrical part, the growth rate **V1** can be relatively high, between 1 and 10 mm/h, as the amount of the generated heat is smaller (seeding, shoulder) or the crystal length is small enough to effectively dissipate the heat (early cylindrical part). Later, the growth rate decreases to a final value **V2** of 0.2 - 1 mm/h to decrease the amount of the generated heat. The decrease of the growth rate **V** can be conducted from the beginning of the growth, as indicated by profiles **P1, P2, P5,** especially when the initial growth rate is high, or later, as indicated by profiles **P3** and **P4**. It can be done linearly or non-linearly, as a continuous decrease, or in step-wise blocks indicated by crystal length segments **L1, L2, L3,** and **L4.** Fig. 3 shows an example of the growth rate from a real growth experiment, where initial **V1** = 1.7 mm/h was constant at the beginning at the first block 0 - **L1,** next decreased in a linear manner in blocks **L1** - **L3** to a final value **V2** = 0.7 mm/h, which was kept constant at the very last block **L3** - **L4** of the crystal growth.

An additional tool for heat management is the use in the growth atmosphere **2** a non-reducing gas of high thermal conductivity, in particular He. This will enhance heat dissipation form the growing crystal **7** through gas convection **C.** Preferably, He in the growth atmosphere **2** is used in the combination with the decrease of the amount of the reflected heat back to the crystal, and with the decrease of the amount of the latent heat of crystallization. He concentration in the growth atmosphere, in addition to oxygen, is between 10 - 95 vol.%.

By using the above-discussed technical solutions it is possible to increase the cylindrical length **L** of highly electrically conducting bulk β-Ga₂O₃ single crystals **7** grown by the Czochralski method, with the diameter larger than 1 inch. Bulk β-Ga₂O₃ single crystals of diameter **D** = 2 inch could be grown with the cylindrical length **L** exceeding 25 mm, between 25 - 50 mm. High electrical conductivity of bulk β-Ga₂O₃ single crystals can be achieved by intentional doping with elements forming shallow donors in this material. The most effective dopants are Si and Sn, but also could be Nb, Zr, and Hf. To achieve high electrical conductivity, the Ga₂O₃ starting material **4** should be doped with SiO₂ of 0.05 - 0.3 mol.%, while SnO₂ of 0.5 - 4 mol.% due to high partial pressure of Sn-containing species. The dopants forming shallow donors can be used separately or in combination. The resulting electrical properties of bulk β-Ga₂O₃ single crystals doped with Si and/or Sn at the above-mentioned concentrations, were as follows (from Hall effect measurements): free electron concentration of 1 -10 ×10¹⁸ cm⁻³, the electron mobility = 50 - 120 cm²V⁻¹s⁻¹, and the resistivity of 0.01 - 0.04 Qcm. 2 inch diameter bulk β-Ga₂O₃ single crystals **7** with such electrical properties enable to fabricate 2 inch diameter, electrically conducting wafers suitable for homoepitaxy and next for power electronic device fabrication in the vertical configuration. In particular, such crystals enable to prepare large wafers with the (010) surface orientation, which shows the highest growth rate of homoepitaxial films by molecular beam epitaxy. Also, other wafer orientations can be prepared, such as (100) or (001), including offcuts by several degrees from those orientations. The bulk β-Ga₂O₃ single crystals obtained by the above-described method and apparatus are of high structural quality, characterized by narrow rocking curves with the full width at half maximum typically below 30 arcsec, making the fabricated wafers suitable for homoepitaxial films of high quality.

## Claims

1. A method for producing electrically conducting bulk β-Ga₂O₃ single crystals by the Czochralski method having a pre-defined cylindrical diameter **(D)** and cylindrical length **(L),** comprising the steps of:
(i) providing, to a growth chamber, a growth furnace **(1)** comprising a noble metal crucible **(3)** with a Ga₂O₃ starting material **(4)** therein, a thermal insulation **(6)** surrounding the crucible **(3)** from all sides with a free space to accommodate a growing bulk β-Ga₂O₃ single crystal **(7),** and an inductive RF coil **(9)** for heating up the crucible **(3)** and control the melt temperature during crystal growth, wherein the RF coil **(9)** is powered by an RF generator, while the growing crystal **(7)** is fixed through a crystal seed **(10),** seed holder **(11),** and a pulling rod **(12)** to a translation and rotating mechanisms;
(ii) providing to the Ga₂O₃ starting material **(4)** a dopant forming a shallow donor in the Ga₂O₃ single crystal **(7);**
(iii) providing to the growth chamber and thus to the growth furnace **(1)** a growth atmosphere **(2)** containing oxygen mixed with at least one non-reducing gas;
(iv) heating up the crucible **(3)** with the Ga₂O₃ starting material **(4)** by the RF coil **(9)** and subsequent melting the Ga₂O₃ starting material **(4);**
(v) dipping the oriented crystal seed **(10)** into the molten starting material **(4);**
(vi) pulling the crystal seed **(10)** up with the translation rate **(TR)** to achieve a predefined growth rate **(V)** while rotating at a rotation rate **(R);**
(vii) while pulling, expanding the seed diameter to a final cylindrical diameter **(D)** of the single crystal **(7);**
(viii) pulling the single crystal **(7)** with the cylindrical diameter **(D)** to a predefined cylindrical length **(L);**
(ix) separating the single crystal **(7)** from the melt, and
(x) cooling the growth furnace **(1)** with the grown single crystal **(7)** down to room temperature,
**characterized in that**
- the step (i) comprises additionally providing to the growth furnace **(1)** an inner thermal insulation **(8)** of low radiative reflectivity **(R)** in the near infrared spectral region of 1 -3 µm to decrease reflections of heat back to the growing single crystal **(7)** and thus to increase the heat dissipation from the growing single crystal **(7);** and
- the steps (vi), (vii), and (viii) of puling the single crystal **(7)** from seeding to separation comprise a dynamic decrease of the growth rate **(V)** from the initial growth rate **(V1)** of 1 - 10 mm/h at the beginning of the growth to a final growth rate **(V2)** of 0.2 - 1 mm/h at the end of the growth when the single crystal **(7)** had achieved the predefined cylindrical length **(L),** to dynamically decrease the latent heat of crystallization as the growth proceeds and the amount of the heat to be dissipated from the growing single crystal **(7).**

2. A method according to claim 1, **characterized in that** the inner thermal insulation **(8)** with low radiative reflectivity **(R)** has high emissivity **(E)** in the near infrared spectral region, above 0.3 at room temperature.

3. A method according to claim 1, **characterized in that** the inner thermal insulation **(8)** with low radiative reflectivity **(R)** has high transmissivity **(T)** in the near infrared spectral region, above 0.3 at room temperature.

4. A method according to any of claims 1 - 3, **characterized in that** the growth rate **(V)** decreases from the initial growth rate **(V1)** to the final growth rate **(V2)** linearly **(P1, P2).**

5. A method according to any of claims 1 - 3, **characterized in that** the growth rate **(V)** decreases from the initial growth rate **(V1)** to the final growth rate **(V2)** non-linearly **(P5).**

6. A method according to any of claims 1 - 5, **characterized in that** the growth rate **(V)** decreases from the initial growth rate **(V1)** to the final growth rate **(V2)** at different rates **(P2, P5).**

7. A method according to any of claims 1 - 6, **characterized in that** the growth rate **(V)** decreases from the initial growth rate **(V1)** to the final growth rate **(V2)** continuously **(P1, P2, P5).**

8. A method according to any of claims 1 - 6, **characterized in that** the growth rate **(V)** decreases from the initial growth rate **(V1)** to the final growth rate **(V2)** in blocks (L1 - L4) combining constant and decreasing growth rates **(P3, P4).**

9. A method according to any of claims 1 - 8, **characterized in that** the step (iii) of providing the growth atmosphere **(2)** comprises providing, in addition to oxygen, a non-reducing gas of high thermal conductivity, preferably He in a concentration of 10 - 95 vol. %.

10. An electrically conducting bulk β-Ga₂O₃ single crystal **(7)** obtained according to any of claims 1 - 9,
**characterized in that**
it has the cylindrical diameter **(D)** larger than one inch, cylindrical length **(L)** larger than 25 mm, and the following electrical properties formed by shallow donors according to Hall effect measurements: free electron concentration of 1 - 10×10¹⁸ cm⁻³, electron mobility of 50 - 120 cm²V⁻¹s⁻¹, and the resistivity of 0.01 - 0.04 Qcm.

11. A bulk β-Ga₂O₃ single crystal **(7)** according to claim 10, **characterized in that** its cylindrical diameter **(D)** is two inch or larger.

12. A bulk β-Ga₂O₃ single crystal **(7)** according to claim 10 or 11, **characterized in that** the dopants forming shallow donors are Si and/or Sn.

13. An apparatus for producing electrically conducting bulk β-Ga₂O₃ single crystals by the Czochralski method having a pre-defined cylindrical diameter **(D)** and cylindrical length **(L),** comprising:
(i) a growth chamber,
(ii) a growth furnace **(1)** comprising a noble metal crucible **(3)** with a Ga₂O₃ starting material **(4)** therein, a thermal insulation **(6)** surrounding the crucible **(3)** from all sides with a free space to accommodate a growing bulk β-Ga₂O₃ single crystal **(7),** and an inductive RF coil **(9)** for heating up the crucible **(3)** and control the melt temperature during crystal growth;
(iii) an RF generator powering the RF coil **(9);**
(iv) translation and rotation mechanisms coupled with a crystal seed **(10)** through a seed holder **(11),** and a pulling rod **(12);**
(v) a scale connected with the pulling rod **(12)** or the growth furnace **(1)** for monitoring growth rate of the bulk β-Ga₂O₃ single crystal **(7),**
**characterized in that**
the growth furnace further comprises an inner thermal insulation **(8)** of low radiative reflectivity **(R)** in the near infrared spectral region of 1 - 3 µm that decreases reflections of heat back to the growing single crystal **(7)** and thus increases the heat dissipation from the growing single crystal **(7).**

14. An apparatus according to claim 13, **characterized in that** the inner thermal insulation **(8)** with low radiative reflectivity **(R)** has high emissivity **(E)** in the near infrared spectral region, above 0.3 at room temperature.

15. An apparatus according to claim 13 or 14, **characterized in that** the inner thermal insulation **(8)** with low radiative reflectivity **(R)** is selected from the group consisting of opaque alumina, zirconia, magnesia, and yttria.

16. An apparatus according to claim 13, **characterized in that** the inner thermal insulation **(8)** with low radiative reflectivity **(R)** has high transmissivity **(T)** in the near infrared spectral region, above 0.3 at room temperature.

17. An apparatus according to claim 13 or 16, **characterized in that** the inner thermal insulation **(8)** with low radiative reflectivity **(R)** is transparent ceramic selected from the group consisting of alumina, yttria, and yttrium aluminum garnet.

18. An apparatus according to claim 13 or 16, **characterized in that** the inner thermal insulation **(8)** with low radiative reflectivity **(R)** is a crystalline sapphire.

19. An apparatus according to any of claims 13 - 18, **characterized in that** the growth atmosphere **(2)** contains, in addition to oxygen, a non-reducing gas of high thermal conductivity, preferably He in a concentration of 5 - 95 vol. %.
